# EUROPEAN PATENT APPLICATION

(11) **EP 3 297 408 A1**
(43) Date of publication of application: **21.03.2018**
(21) Application number: 15894634.3
(22) Date of filing: 11.06.2015
(51) Int. Cl.: H05H 1/00, H03L 7/085, H03D 13/00

(54) **METHOD AND SYSTEM FOR REAL-TIME CALCULATING PHASE SHIFT SIGNAL, PLASMA DIAGNOSTIC METHOD AND SYSTEM**

(71) Applicant: Southwestern Institute of Physics, Chengdu, Sichuan 614001 (CN)
(72) Inventor: YAN, Zhou, Chengdu Sichuan 610041 (CN)
(74) Representative: Style, Kelda Camilla Karen
(86) International application number: PCT/CN2015/081243
(87) International publication number: WO 2016/197364

(57) **Abstract**

A method and a system for calculating a dynamically phase-shifted signal in real-time, wherein the method comprises following steps: respectively segmenting intermediate frequency signals of a measurement channel and a reference channel; respectively reading the intermediate frequency signals of the measurement channel and the reference channel for a current time period, and converting the intermediate frequency signals of the measurement channel and the reference channel into digital signals by A/D conversion; respectively converting the obtained digital signals of the measurement channel and the reference channel for the current time period into frequency domain signals by Fourier transform, meanwhile respectively finding accurate frequencies for the current time period; according to the accurate frequencies for the current time period, performing conjugate calculation on the frequency domain signals of the reference channel and the measurement channel for the current time period to obtain a phase difference. The method and the system for calculating the dynamically phase-shifted signal in real-time can realize unattended and reliable phase calculation and phase output in real time. The diagnostic method and the system for the nuclear fusion plasma using the method and the system for calculating the phase-shifted signal in real-time can further reliably realize the unattended and real-time measurement of the electron density and the current density.

## Description

### FIELD OF THE INVENTION

The present invention relates to the field of nuclear fusion plasma diagnosis, and more particularly to a method and a system for calculating a phase-shifted signal in real-time that can be used in real-time calculation for dynamic phase shift of multiple intermediate frequency signals of polarized light measurement technology. The present invention also relates to a diagnostic method and a system for a plasma applying the method and the system for calculating a phase-shifted signal in real-time.

### BACKGROUND OF THE INVENTION

In research of the apparatus and physics for nuclear fusion, the electron density and the current density of the plasma are the most basic and the most critical physical parameters in studying plasma behavior and physics. Relevant international and domestic research institutes are constantly investing manpower and material resources to research and develop more reliable diagnostic techniques and methods capable of processing high temporal and spatial resolution in real-time so as to meet the research requirements for new physical phenomena that arise continually.

Generally, the distributions of the electric density and the current density of the plasma are measured by laser polarized interferometer, the working principle of which is laser interference technology. Namely, each of the beams from the same laser source is split into two beams via beam splitter. One beam passes through measurement medium (i.e. measure beam), while the other one does not pass through measurement medium (i.e. reference beam). Refractive index of the measurement medium is obtained by comparing the phase changes of the measure beam and the reference beam. The electron density and the current density are obtained by using equations of dispersion relation. As the currently used laser detector has a low detectivity for the high frequency laser, an optical signal with a high frequency is generally converted into a modulated signal with a low frequency by laser frequency modulation technology, wherein the low frequency signal is also called intermediate frequency signal.

In the past, the intermediate frequency signal of the laser interferometer for measuring the plasma density is generated by doppler shift of the laser beam irradiated on the rotating cylindrical grating. Due to even rotation speed of the grating, the frequency of the generated intermediate frequency signal is fixed at, for example, 10 kHz. Amplification and filtration in electronics are fixed at a center frequency of 10 kHz, and the frequency band for filtering can be 10 kHz ± 2 kHz. The subsequent signal amplification and phase difference calculation can be easily processed and calculated with inherent electronics circuits. Because of the fixed frequency, phase comparison compares the phases of the reference channel and the measurement channel at the same time point to obtain the phase difference. In such method, an excessive increase in the mechanical rotation speed of the grating is improper. Otherwise the dynamic imbalance occurs easily. Therefore the time resolution of the measurement system can only be around 100 microseconds, which is unable to satisfy the requirements of physics research.

At present, the international dominant polarized interferometer employs laser difference frequency technology to generate the required intermediate frequency signal (output signals of two lasers with slightly different wavelengths subtract from each other to generate one intermediate frequency signal).That is, three or two lasers are used to generate three or one intermediate frequency signals with difference frequency technology, wherein the intermediate frequency signals are split into measurement channel and reference channel via the beam splitter. The phase of the intermediate frequency signals passing through the plasma is compared with the phase of the intermediate frequency signals not passing through the plasma to obtain the density and the current parameters. Although laser difference frequency technology is able to generate an intermediate frequency signal with a higher frequency that can improve time resolution of the system, the output frequency of an individual laser drifts over time since the lasers of the system are affected by changes in environmental temperature, resulting in the frequency shift of the intermediate frequency signal. Thus the traditional phase difference meter is difficult to confirm the frequency of the intermediate frequency signal and even cannot normally calculate the value of the phase. The phase comparison and calculation of the similar measurement system now used at home and aboard cannot realize real-time calculation online, and can only be processed offline or depend on workers to dynamically adjust the laser parameters to meet the operating range of the phase difference meter.

### BRIEF SUMMARY OF THE INVENTION

The technical problem solved by the present invention is that in the prior art, the real-time calculation of a phase difference is hard to be implemented during the nuclear fusion experiment due to the frequency drift of the laser. Then a method for calculating a dynamically phase-shifted signal in real-time capable of being applied in the case that the frequency of laser drifts is provided. The present invention further provides a system for calculating a dynamically phase-shifted signal in real-time as well as a diagnostic method and a system for a plasma using the aforementioned method and system for calculating a phase-shifted signal in real-time.

In order to solve the aforementioned technical problem, the technical schemes adopted by the present invention are as follows:
A method for calculating a dynamically phase-shifted signal in real-time, comprising following steps:
   S01: respectively segmenting intermediate frequency signals of a measurement channel and a reference channel;
   S02: respectively reading the intermediate frequency signals of the measurement channel and the reference channel for a current time period, and converting the intermediate frequency signals of the measurement channel and the reference channel into digital signals by A/D conversion;
   S03: respectively converting the obtained digital signals of the measurement channel and the reference channel for the current time period into frequency domain signals by Fourier transform, meanwhile respectively finding accurate frequencies of the intermediate frequency signals of the measurement channel and the reference channel for the current time period;
   S04: according to the accurate frequencies of the intermediate frequency signals of the measurement channel and the reference channel for the current time period, performing conjugate calculation on the frequency domain signals of the reference channel and the measurement channel for the current time period to obtain a phase difference for the current time period between the intermediate frequency signals of the measurement channel and the reference channel;
   S05: Repeating steps S02 through S04 to calculate a phase difference for a next time period between the intermediate frequency signals of the measurement channel and the reference channel.

Preferably, a filtering step is further comprised between step S03 and step S04:
using the accurate frequencies for the current time period of the intermediate frequency signals of the measurement channel and the reference channel found in step S03 as center frequencies, respectively band-pass filtering the frequency domain signals for the current time period of the measurement channel and the reference channel obtained in step S03 within a set frequency band, setting the frequency domain signals outside the frequency band to zero, and in step S04, calculating the phase difference with filtered frequency domain signals.

Preferably, step S03, step S04 and/or the filtering step are implemented with FPGA technology.

Preferably, while the measurement channel comprises three intermediate frequency signals, correspondingly the reference channel also comprises three intermediate frequency signals. The phase differences of three pairs of the intermediate frequency signals in each time period are respectively and simultaneously calculated with steps S01 through S05.

The present invention further provides a diagnostic method for a nuclear fusion plasma, using the method for calculating the dynamically phase-shifted signal in real-time to calculate the phase difference in real-time, and setting a following step after step S04:
calculating an electron density and a current density for the current time period according to the obtained a phase difference, and storing, displaying and/or feeding back a calculation result.

The present invention further provides a system for calculating a dynamically phase-shifted signal in real-time, comprising:
a measurement channel A/D conversion module used for reading an intermediate frequency signal of a measurement channel for a current time period, and converting the intermediate frequency signal of the measurement channel into digital signal by A/D conversion;
a reference channel A/D conversion module used for reading an intermediate frequency signal of a reference channel for the current time period, and converting the intermediate frequency signal of the reference channel into digital signal by A/D conversion;
a measurement channel fast Fourier transform module used for fast Fourier transforming the digital signal from the measurement channel A/D conversion module to obtain a frequency domain signal, and finding an accurate frequency of the intermediate frequency signal of the measurement channel for the current time period;
a reference channel fast Fourier transform module used for fast Fourier transforming the digital signal from the reference channel A/D conversion module to obtain a frequency domain signal, and finding an accurate frequency of the intermediate frequency signal of the reference channel for the current time period;
a phase comparison module for performing conjugate calculation on the frequency domain signal of the reference channel and the frequency domain signal of the measurement channel for the current time period according to the accurate frequency of the intermediate frequency signal of the measurement channel and the accurate frequency of the intermediate frequency signal of the reference channel for the current time period so as to obtain a phase difference for the current time period between the intermediate frequency signal of the measurement channel and the intermediate frequency signal of the reference channel.

Preferably, the system for calculating the dynamically phase-shifted signal in real-time further comprises a measurement channel filter module and/or a reference channel filter module:
the measurement channel filter module uses the accurate frequency for the current time period of the intermediate frequency signal of the measurement channel found via the measurement channel fast Fourier transform module as a center frequency to band-pass filter the frequency domain signal for the current time period of the measurement channel obtained via the measurement channel fast Fourier transform module within a set frequency band, and sets frequency domain signals outside the frequency band to zero, and the phase comparison module calculates the phase difference with filtered frequency domain signals;
the reference channel filter module uses the accurate frequency for the current time period of the intermediate frequency signal of the reference channel found via the reference channel fast Fourier transform module as a center frequency to band-pass filter the frequency domain signal for the current time period of the reference channel obtained via the reference channel fast Fourier transform module within a set frequency band, and sets frequency domain signals outside the frequency band to zero, and the phase comparison module calculates the phase difference with filtered frequency domain signals.

Preferably, the measurement channel fast Fourier transform module, the reference channel fast Fourier transform module, the measurement channel filter module, the reference channel filter module and/or the phase comparison module are programmed onto a FPGA chip.

Finally, the present invention further provides a diagnostic system for a nuclear fusion plasma comprising the system for calculating the dynamically phase-shifted signal in real-time, wherein the diagnostic system for the nuclear fusion plasma further comprises an electron density/current density calculation module, the electron density/current density calculation module calculates an electron density and a current density of the nuclear fusion plasma in real-time according to the phase difference calculated by the system for calculating the dynamically phase-shifted signal in real-time.

The electron density/current density calculation module is preferably programmed onto the FPGA chip.

Preferably, the diagnostic system for the nuclear fusion plasma further comprises a storage module for storing a calculation result, a display module for displaying the calculation result and/or a feedback system for feeding back the calculation result.

The beneficial effects of the present invention are as follows:
The method and the system for calculating the dynamically phase-shifted signal in real-time of the present invention use FPGA technology and employ a new and dynamical intermediate frequency recognition method, realizing unattended and reliable phase calculation and phase output in real time. The diagnostic method and the system for the nuclear fusion plasma using the method and the system for calculating the phase-shifted signal in real-time can further reliably realize the unattended and real-time measurement of the electron density and the current density, particularly:
The frequency of intermediate frequency signal is dynamically confirmed in the time period defined by the time resolution of system, avoiding fail measurement of the phase difference meter having a fixed intermediate frequency due to the intermediate frequency drift;
Signal filtration and phase difference calculation are set after frequency judgment of the intermediate frequency signal, significantly improving the accuracy of phase calculation;
Meanwhile, the long measuring time is segmented into a plurality of short time periods, guaranteeing the real-time signal output, and providing data for feedback control of Tokamak density and the current density.

### DESCRIPTION OF THE DRAWINGS

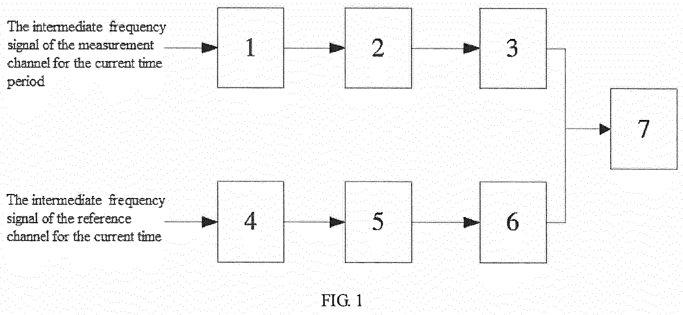

Fig. 1 is a block diagram showing structure of the system for calculating the dynamically phase-shifted signal in real-time of the present invention,
in which:
1 measurement channel A/D conversion module, 2 measurement channel filter module, 3 measurement channel fast Fourier transform module, 4 reference channel A/D conversion module, 5 reference channel filter module, 6 reference channel fast Fourier transform module, 7 phase comparison module.

### DETAILED DESCRIPTION OF THE PREFERRED EMBODIMENTS

The technical schemes and beneficial effects of the present invention will now be further illustrated with reference to accompany drawing and the specific embodiments.

A method for calculating a dynamically phase-shifted signal in real-time of the present invention, comprising following steps:
S01: respectively segmenting intermediate frequency signals of a measurement channel and a reference channel;
S02: respectively reading the intermediate frequency signals of the measurement channel and the reference channel for a current time period, and converting the intermediate frequency signals of the measurement channel and the reference channel into digital signals by A/D conversion;
S03: respectively converting the obtained digital signals of the measurement channel and the reference channel for the current time period into frequency domain signals by Fourier transform, meanwhile respectively finding accurate frequencies of the intermediate frequency signals of the measurement channel and the reference channel for the current time period ;
S04: according to the accurate frequencies of the intermediate frequency signals of the measurement channel and the reference channel for the current time period, performing conjugate calculation on the frequency domain signals of the reference channel and the measurement channel for the current time period to obtain a phase difference for the current time period between the intermediate frequency signals of the measurement channel and the reference channel;
S05: Repeating steps S02 through S04 to calculate a phase difference for a next time period between the intermediate frequency signals of the measurement channel and the reference channel.

Correspondingly, Fig. 1 shows a system for calculating a dynamically phase-shifted signal in real-time provided by the present invention, comprising:
a measurement channel A/D conversion module 1 used for reading an intermediate frequency signal of a measurement channel for a current time period, and converting the intermediate frequency signal of the measurement channel into digital signal by A/D conversion;
a reference channel A/D conversion module 4 used for reading an intermediate frequency signal of a reference channel for the current time period, and converting the intermediate frequency signal of the reference channel into digital signal by A/D conversion;
a measurement channel fast Fourier transform module 3 used for fast Fourier transforming the digital signal from the measurement channel A/D conversion module to obtain a frequency domain signal, and finding an accurate frequency of the intermediate frequency signal of the measurement channel for the current time period;
a reference channel fast Fourier transform module 6 used for fast Fourier transforming the digital signal from the reference channel A/D conversion module to obtain a frequency domain signal, and finding an accurate frequency of the intermediate frequency signal of the reference channel for the current time period;
a phase comparison module 7 for performing conjugate calculation on the frequency domain signal of the reference channel and the frequency domain signal of the measurement channel for the current time period according to the accurate frequency of the intermediate frequency signal of the measurement channel and the accurate frequency of the intermediate frequency signal of the reference channel for the current time period so as to obtain a phase difference for the current time period between the intermediate frequency signal of the measurement channel and the intermediate frequency signal of the reference channel.

In short, the method for calculating the dynamically phase-shifted signal in real-time of the present invention actually segments the intermediate frequency signals of the measurement channel and the reference channel into a plurality of reasonable small segments according to the time. The term of reasonable small segments means that time period of each of the reasonable small segments can meet the requirements for measuring time resolution, and the data in each of the reasonable small segments can be Fourier transformed within an accuracy range. For example, a frequency of the intermediate frequency signal is 1 MHz, a sampling rate is 12.5 MHz, and a time period is 20.48 microseconds. According to the present invention and the prior art, the person skilled in the art can accomplish the segmenting process. The signal of each of the small segments is recorded into an electronics chip by A/D conversion. The accurate frequency of the intermediate frequency signal can be found by Fourier transform. According to the found intermediate frequency signal value, filtration is performed within a set frequency band to reduce the noise. After filtration, the reference channel signal is compared with the measurement channel signal to obtain the phase difference between the intermediate frequency signals of the measurement channel and the reference channel for the current time period. Then obtaining and outputting the density and the current density data. Next, the phase for the next time period is calculated in the same way. The density and the current density data for the entire time are obtained by connecting all the data for each time period.

As described above, in order to reduce noise to improve the accuracy of phase calculation, the method for calculating the dynamically phase-shifted signal in real-time of the present invention can set a filtering step between step S03 and step S04:
using the accurate frequencies for the current time period of the intermediate frequency signals of the measurement channel and the reference channel found in step S03 as center frequencies, respectively band-pass filtering the frequency domain signals for the current time period of the measurement channel and the reference channel obtained in step S03 within a set frequency band, setting the frequency domain signals outside the frequency band to zero, and in step S04, calculating the phase difference with filtered frequency domain signals.

Correspondingly, the system for calculating the dynamically phase-shifted signal in real-time provided in the present invention can also dispose a measurement channel filter module 2 and/or reference channel filter module 5:
The measurement channel filter module uses the accurate frequency for the current time period of the intermediate frequency signal of the measurement channel found via the measurement channel fast Fourier transform module as a center frequency to band-pass filter the frequency domain signal for the current time period of the measurement channel obtained via the measurement channel fast Fourier transform module within a set frequency band, and sets frequency domain signals outside the frequency band to zero, and the phase comparison module calculates the phase difference with filtered frequency domain signals;
The reference channel filter module uses the accurate frequency for the current time period of the intermediate frequency signal of the reference channel found via the reference channel fast Fourier transform module as a center frequency to band-pass filter the frequency domain signal for the current time period of the reference channel obtained via the reference channel fast Fourier transform module within a set frequency band, and sets frequency domain signals outside the frequency band to zero, and the phase comparison module calculates the phase difference with filtered frequency domain signals.

The method for calculating the dynamically phase-shifted signal in real-time of the present invention selects the frequency domain signals to calculate the phase difference (the article Rev. Sci. Instrum. Vol.68 No.1, p902 (1997) provides a reference to the calculation method), resulting in significant increase in computational efficiency as the calculation amount is smaller than that of the traditional calculation method. Also, FPGA is able to realize the fast and real-time calculation. Step S03, step S04 and/or the filtering step are implemented with FPGA technology, significantly improving the real-time ability of the calculation and completely satisfying the demands of existing nuclear fusion experiments. Correspondingly, in the system for calculating the dynamically phase-shifted signal in real-time of the present invention, the measurement channel fast Fourier transform module, the reference channel fast Fourier transform module, the measurement channel filter module, the reference channel filter module and/or the phase comparison module are programmed onto a FPGA chip.

In some systems, the measurement channel comprises three intermediate frequency signals, and the reference channel correspondingly comprises three intermediate frequency signals. The phase differences of the three pairs of the intermediate frequency signals in each time period are respectively and simultaneously calculated with steps S01 through S05.

The diagnostic method for the nuclear fusion plasma on the basis of the aforementioned method for calculating the dynamically phase-shifted signal in real-time employs the method for calculating the dynamically phase-shifted signal in real-time to calculate the phase difference, and sets the following step after step S04:
calculating an electron density and a current density according to the obtained phase difference.

And a step of storing, displaying and/or feeding back the calculated result can be further set as needed.

Correspondingly, in addition to the system for calculating the dynamically phase-shifted signal in real-time, the diagnostic system for a nuclear fusion plasma provided in the present invention further comprises an electron density/current density calculation module, wherein the electron density/current density calculation module calculates an electron density and a current density of the nuclear fusion plasma in real-time according to the phase difference calculated by the system for calculating the dynamically phase-shifted signal in real-time. And a storage module for storing a calculation result, a display module for displaying the calculation result and/or a feedback system for feeding back the calculation result can be set as needed.

The operation process of the diagnostic system for the nuclear fusion plasma using the system for calculating the dynamically phase-shifted signal in real-time of the present invention is as follows:
Before phase comparison, some signal transformation processes such as conversion from an analog signal into a digital signal, confirmation of the intermediate frequency, and band-pass amplification of a signal are performed respectively on the signal of the measurement channel and the signal of the reference channel. The measurement signal and the reference signal from the detectors are analog signals comprising one or three intermediate frequencies. Generally, the signal amplitude is 1-4 volts, and the signal frequency falls within a range of 600 kHz-3 MHz. The two A/D conversion modules convert the analog signals come from the detectors into digital signals. The two fast Fourier transform modules transform the digitized time domain signals to frequency domain signals and simultaneously confirm the specific frequency values of the intermediate frequency signals. In the event that each of the signals comprises three intermediate frequencies, then the frequency value of the three intermediate frequencies are confirmed respectively. In the event that each of the signals only comprises one intermediate frequency, one frequency value needs to be found. The filter module dynamically uses the found intermediate frequency value as the center to determine a certain frequency band (e.g. the intermediate frequency is 1 MHz, and the width of the filter window is 195 kHz) and sets the frequency domain signals outside of the frequency band to zero. Each of the intermediate frequencies is respectively used for the filtration of signals if three intermediate frequencies are comprised. The filtered measure signal and reference signal are transmitted to the phase comparison module 7. The conjugate calculation on the reference signal and the measurement signal is performed to obtain a phase difference. According to the phase difference, the electron density and the current density of the plasma are calculated (the phase difference is proportional to the electron density and the current density). The calculation result can be stored in the computer. Meanwhile, the phase difference signal, the electron density and the current density are output to the display or other hardware control systems, e.g. the density feedback system. Then a time period operation is completed. The processes described above are repeated in the next time period until the discharge is finished.

Next, the technical schemes of the present invention are further illustrated according to one embodiment:
A polarized interferometer comprising three HCOOH lasers has a laser wavelength of 432 micrometers. The beams of the three lasers form the measurement beam and the reference beam. And the beams merge into one beam respectively before enter the measurement channel detector and the reference channel detector. Each of the merged beams comprises three intermediate frequency signals generated by the difference frequency of the three different lasers, wherein the frequencies are 700 kHz, 1.2 MHz, and 1.9 MHz respectively. The sampling rate is 12.5 MHz. At the beginning of the discharge, two sets of data are selected respectively from the signal flows of the measurement channel detector and the reference channel detector and transmitted to the phase comparator, wherein each of the two sets of data comprises 256 points. The signals of the measurement channel and the reference channel are converted to the digital signals by A/D conversion. The signals of the measurement channel and the reference channel are respectively Fourier transformed to find the three intermediate frequencies subsequently having the center frequency of 700 kHz, 1.2 MHz, and 1.9 MHz. The width of the filter window is set to 195 kHz. The three intermediate frequencies are used for filtration of each of the signals in the condition that the peak value is the center and the filter window is the frequency band. Then the signals of the measurement channel and the reference channel are transmitted to the phase comparison module 7. The correspondent measurement and comparison of the measurement phase and the reference phase for each of the intermediate frequencies are carried out. The conjugate calculation on the signals of the reference channel and the measurement channel is performed to obtain phase difference. With the equations of dispersion relation, the values of the electron density and the current density are obtained and then outputted to the display and the input terminal of the density feedback controller. Since the entire signal processing flow uses FPGA technology, the time for completing one circulation is 180 microseconds. Thereafter, the data of the next time period is selected to repeat the above processes until the discharge is over.

The people ordinarily skilled in the art will appreciate that the embodiments described herein is to assist the reader in understanding the principles of the present invention. It is to be understood that the protection scope of present invention needs not be limited to such particular statements and embodiments. Based on the technical teachings disclosed in the present invention, various modifications and combinations that can be made without departing from the spirit of the present invention by the people ordinarily skilled in the art are still within the protection scope of the present invention.

## Claims

1. A method for calculating a dynamically phase-shifted signal in real-time, comprising following steps:
S01: respectively segmenting intermediate frequency signals of a measurement channel and a reference channel;
S02: respectively reading the intermediate frequency signals of the measurement channel and the reference channel for a current time period, and converting the intermediate frequency signals of the measurement channel and the reference channel into digital signals by A/D conversion;
S03: respectively converting the obtained digital signals of the measurement channel and the reference channel for the current time period into frequency domain signals by Fourier transform, meanwhile respectively finding accurate frequencies of the intermediate frequency signals of the measurement channel and the reference channel for the current time period ;
S04: according to the accurate frequencies of the intermediate frequency signals of the measurement channel and the reference channel for the current time period, performing conjugate calculation on the frequency domain signals of the reference channel and the measurement channel for the current time period to obtain a phase difference for the current time period between the intermediate frequency signals of the measurement channel and the reference channel;
S05: Repeating steps S02 through S04 to calculate a phase difference for a next time period between the intermediate frequency signals of the measurement channel and the reference channel.

2. The method for calculating the dynamically phase-shifted signal in real-time according to claim 1, wherein a filtering step is further comprised between step S03 and step S04: using the accurate frequencies for the current time period of the intermediate frequency signals of the measurement channel and the reference channel found in step S03 as center frequencies, respectively band-pass filtering the frequency domain signals for the current time period of the measurement channel and the reference channel obtained in step S03 within a set frequency band, setting the frequency domain signals outside the frequency band to zero, and in step S04, calculating the phase difference with filtered frequency domain signals.

3. The method for calculating the dynamically phase-shifted signal in real-time according to claim 2,wherein step S03, step S04 and/or the filtering step are implemented with FPGA technology.

4. The method for calculating the dynamically phase-shifted signal in real-time according to any of claims 1-3, wherein while the measurement channel comprises three intermediate frequency signals, correspondingly the reference channel also comprises three intermediate frequency signals, three of the phase difference of three pairs of the intermediate frequency signals in each time period are respectively and simultaneously calculated with steps S01 through S05.

5. A diagnostic method for a nuclear fusion plasma, using the method for calculating the dynamically phase-shifted signal in real-time according to any of claims 1-4 to calculate the phase difference, and setting a following step after step S04: calculating an electron density and a current density for the current time period according to the obtained phase difference, and storing, displaying and/or feeding back a calculation result.

6. A system for calculating a dynamically phase-shifted signal in real-time, comprising:
a measurement channel A/D conversion module used for reading an intermediate frequency signal of a measurement channel for a current time period, and converting the intermediate frequency signal of the measurement channel into digital signal by A/D conversion;
a reference channel A/D conversion module used for reading an intermediate frequency signal of a reference channel for the current time period, and converting the intermediate frequency signal of the reference channel into digital signal by A/D conversion;
a measurement channel fast Fourier transform module used for fast Fourier transforming the digital signal from the measurement channel A/D conversion module to obtain a frequency domain signal, and finding an accurate frequency of the intermediate frequency signal of the measurement channel for the current time period;
a reference channel fast Fourier transform module used for fast Fourier transforming the digital signal from the reference channel A/D conversion module to obtain a frequency domain signal, and finding an accurate frequency of the intermediate frequency signal of the reference channel for the current time period;
a phase comparison module for performing conjugate calculation on the frequency domain signal of the reference channel and the frequency domain signal of the measurement channel for the current time period according to the accurate frequency of the intermediate frequency signal of the measurement channel and the accurate frequency of the intermediate frequency signal of the reference channel for the current time period so as to obtain a phase difference for the current time period between the intermediate frequency signal of the measurement channel and the intermediate frequency signal of the reference channel.

7. The system for calculating the dynamically phase-shifted signal in real-time according to claim 6, wherein the system further comprises a measurement channel filter module and/or a reference channel filter module:
the measurement channel filter module uses the accurate frequency for the current time period of the intermediate frequency signal of the measurement channel found via the measurement channel fast Fourier transform module as a center frequency to band-pass filter the frequency domain signal for the current time period of the measurement channel obtained via the measurement channel fast Fourier transform module within a set frequency band, and sets frequency domain signals outside the frequency band to zero, and the phase comparison module calculates the phase difference with filtered frequency domain signals;
the reference channel filter module uses the accurate frequency for the current time period of the intermediate frequency signal of the reference channel found via the reference channel fast Fourier transform module as a center frequency to band-pass filter the frequency domain signal for the current time period of the reference channel obtained via the reference channel fast Fourier transform module within a set frequency band, and sets frequency domain signals outside the frequency band to zero, and the phase comparison module calculates the phase difference with filtered frequency domain signals.

8. The system for calculating the dynamically phase-shifted signal in real-time according to claim 7, wherein the measurement channel fast Fourier transform module, the reference channel fast Fourier transform module, the measurement channel filter module, the reference channel filter module and/or the phase comparison module are programmed onto a FPGA chip.

9. A diagnostic system for a nuclear fusion plasma comprising the system for calculating the dynamically phase-shifted signal in real-time according to any of claims 6-8, wherein the diagnostic system for the nuclear fusion plasma further comprises an electron density/current density calculation module, the electron density/current density calculation module calculates an electron density and a current density of the nuclear fusion plasma in real-time according to the phase difference calculated by the system for calculating the dynamically phase-shifted signal in real-time.

10. The diagnostic system for the nuclear fusion plasma according to claim 9, wherein the electron density/current density calculation module is programmed onto a FPGA chip, and the diagnostic system for the nuclear fusion plasma further comprises a storage module for storing a calculation result, a display module for displaying the calculation result and/or a feedback system for feeding back the calculation result.
